# EUROPEAN PATENT APPLICATION

(11) **EP 3 926 806 A1**
(43) Date of publication of application: **22.12.2021**
(21) Application number: 20911295.2
(22) Date of filing: 04.09.2020
(51) Int. Cl.: H02M 1/42

(54) **CURRENT DETECTING DEVICE AND POWER FACTOR CORRECTION DEVICE**

(30) Priority: 31.12.2019 CN 201911416423
(71) Applicant: Huawei Digital Power Technologies Co., Ltd., Shenzhen, 518043 (CN)
(72) Inventor: REN, Jie, Shenzhen, Guangdong 518129 (CN); ZHANG, Xue, Shenzhen, Guangdong 518129 (CN); ZHAO, Weiyang, Shenzhen, Guangdong 518129 (CN)
(74) Representative: Pfenning, Meinig & Partner mbB
(86) International application number: PCT/CN2020/113364
(87) International publication number: WO 2021/135343

(57) **Abstract**

This application provides a current detection apparatus, configured to detect an alternating current flowing through a power inductor. The current detection apparatus includes: a first induction circuit including a first auxiliary inductor that is coupled to the power inductor; a second induction circuit including a second auxiliary inductor that is coupled to the power inductor; a detection node between the first induction circuit and the second induction circuit, where the detection node is configured to output a detection signal; a first switching transistor that is connected in parallel to the first induction circuit; and a second switching transistor that is connected in parallel to the second induction circuit. When an alternating current power supply of a circuit in which the power inductor is located is positive, the first switching transistor is turned on to short-circuit the first induction circuit, and the second switching transistor is turned off to enable the second induction circuit to output the detection signal. When the alternating current power supply is negative, the second switching transistor is turned on to short-circuit the second induction circuit, and the first switching transistor is turned off to enable the first induction circuit to output the detection signal. When one auxiliary inductor of the power inductor outputs the detection signal, the other auxiliary inductor of the power inductor is short-circuited, so that detection accuracy is improved.

## Description

This application claims priority to Chinese Patent Application No. 201911416423.0, filed with the Chinese Patent Office on December 31, 2019, and entitled "CURRENT DETECTION APPARATUS AND POWER FACTOR CORRECTION APPARATUS", which is incorporated herein by reference in its entirety.

### TECHNICAL FIELD

This application relates to the current detection field, and in particular, to a current detection apparatus and a power factor correction apparatus.

### BACKGROUND

In some circuits, a voltage at two ends of some components in the circuits or a current flowing through some components needs to be detected, so as to control the circuits. When an alternating current (alternating current, AC) power supply supplies power to some circuits, a direction of a current flowing through some components in the circuits may change as the alternating current power supply alternates between positive and negative.

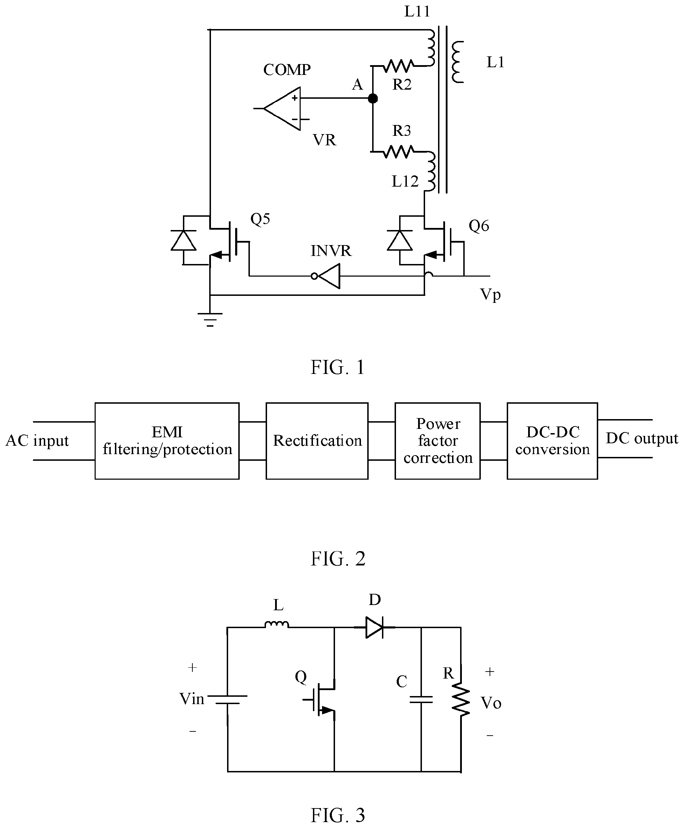

As shown in FIG. 1, an inductor in a circuit is used as an example. To detect an alternating current in the inductor, a first auxiliary winding L11 and a second auxiliary winding L12 may be both coupled to the inductor, to sense the current on the inductor and generate an induced electromotive force. The first auxiliary winding L11 and the second auxiliary winding L12 are connected in series. A detection node A may be located between the first auxiliary winding L11 and the second auxiliary winding L12. A switching transistor Q5 is connected in series to the first auxiliary winding L11, and a switching transistor Q6 is connected in series to the second auxiliary winding L12. The switching transistors Q5 and Q6 are controlled to turn on or off based on whether an alternating current power supply is positive or negative. In this way, when the alternating current is positive, the first auxiliary winding L11 is disconnected from a ground potential, and the second auxiliary winding L12 is connected to the ground potential, so that an induced electromotive force generated by the second auxiliary winding L12 can be measured. On the contrary, when the alternating current is negative, the second auxiliary winding L12 is disconnected from the ground potential, and the first auxiliary winding L11 is connected to the ground potential, so that an induced electromotive force generated by the first auxiliary winding L11 is measured. The two auxiliary windings L11 and L12 and the two switching transistors Q5 and Q6 are used, so that an electrical potential of the detection node A does not alternate between positive and negative as the alternating current power supply alternates between positive and negative. The alternating current in the inductor can be measured based on the electrical potential of the detection node A by using a simple comparator circuit.

When the alternating current is positive, the switching transistor Q5 that is connected in series to the first auxiliary winding L11 is turned off, the first auxiliary winding L11 is disconnected from a reference potential, and a branch potential of the first auxiliary winding L11 is floating. The inductor L11 and the switching transistor Q5 are connected by using a conducting wire, and the detection node A and the inductor L11 are connected by using a conducting wire. Therefore, a relatively long conducting wire may exist between the detection node A and the switching transistor Q5. Due to electromagnetic coupling between conducting wires, when an operating frequency of the circuit is relatively high, potentials of the conducting wires in the circuit may be subject to interference. When a potential of a conducting wire is floating and the conducting wire is relatively long, the circuit is more susceptible to interference. When the conducting wire between the detection node A and the switching transistor Q5 is subject to electromagnetic interference of other parts and components in the circuit, a potential of a connection point of the inductor L11 and the inductor L12 may be affected, causing relatively large interference and affecting detection accuracy.

### SUMMARY

This application provides a current detection apparatus, where when one auxiliary inductor of a power inductor outputs a detection signal, the other auxiliary inductor of the power inductor is short-circuited, to prevent an open circuit of the other auxiliary inductor from interfering with the detection signal, thereby improving detection accuracy.

According to a first aspect, a current detection apparatus is provided. The current detection apparatus is configured to detect an alternating current flowing through a power inductor. The current detection apparatus includes: a first induction circuit and a second induction circuit, where the first induction circuit includes a first auxiliary inductor that is coupled to the power inductor, the second induction circuit includes a second auxiliary inductor that is coupled to the power inductor, and a detection node between a first end of the first induction circuit and a first end of the second induction circuit is configured to output a detection signal; and a first switching transistor and a second switching transistor, where the first switching transistor and the first induction circuit are connected in parallel, and the second switching transistor and the second induction circuit are connected in parallel. When an alternating current power supply of a circuit in which the power inductor is located is positive, the first switching transistor is turned on to short-circuit the first induction circuit, and the second switching transistor is turned off to enable the second induction circuit to output the detection signal; or when the alternating current power supply of the circuit in which the power inductor is located is negative, the second switching transistor is turned on to short-circuit the second induction circuit, and the first switching transistor is turned off to enable the first induction circuit to output the detection signal.

When one auxiliary inductor of the power inductor outputs the detection signal, the other auxiliary inductor of the power inductor is short-circuited, to prevent an open circuit of the other auxiliary inductor from interfering with the detection signal, thereby improving detection accuracy.

With reference to the first aspect, in some possible implementations, the second induction circuit includes a first current limiting resistor that is connected in series to the second auxiliary inductor.

The first current limiting resistor is connected in series to the second auxiliary inductor, to reduce a current of the second induction circuit when the second induction circuit is short-circuited, thereby reducing power consumption.

With reference to the first aspect, in some possible implementations, the current detection apparatus includes a voltage divider circuit, and the voltage divider circuit includes a first resistive circuit and a second resistive circuit that are connected in series. The voltage divider circuit is connected in series to the first induction circuit and the second induction circuit. A first end of the voltage divider circuit is connected to the first end of the first induction circuit, a second end of the voltage divider circuit is connected to the first end of the second induction circuit, and the detection node is located between the first resistive circuit and the second resistive circuit.

The voltage divider circuit is connected in series to the first induction circuit and the second induction circuit, and a connection point of the two resistive circuits in the voltage divider circuit serves as the detection node, so that the first induction circuit and the second induction circuit can share the same voltage divider circuit, reducing a quantity of resistors in the current detection apparatus and decreasing a footprint.

With reference to the first aspect, in some possible implementations, the first switching transistor is an N-type metal-oxide semiconductor field-effect transistor NMOS. A source of the first switching transistor is connected to a reference ground potential of the current detection apparatus.

The source of the NMOS that serves as the first switching transistor is grounded, to reduce difficulty in controlling the first switching transistor, thereby lowering a requirement on a control signal.

With reference to the first aspect, in some possible implementations, the current detection apparatus further includes a comparator, configured to receive the detection signal, compare the detection signal with a reference signal, and output a comparison signal.

The comparator is configured to compare the detection signal with the reference signal, to implement current detection.

With reference to the first aspect, in some possible implementations, the power inductor is an inductor in a bridgeless power factor correction PFC apparatus. The power inductor is configured to charge a capacitor in the PFC apparatus in a forward manner. When an alternating current power supply of the PFC apparatus is positive, the power inductor is configured to receive electric energy from the alternating current power supply to perform forward charging. When the alternating current power supply of the PFC apparatus is negative, the power inductor is configured to receive electric energy from the alternating current power supply to perform reverse charging.

According to a second aspect, a bridgeless power factor correction PFC apparatus is provided. The PFC apparatus includes the power inductor, a capacitor, and the current detection apparatus according to the first aspect. The power inductor is configured to supply power to the capacitor in the PFC apparatus in a forward manner. When an alternating current power supply of the PFC apparatus is positive, the power inductor receives electric energy from the alternating current power supply to perform forward charging. When the alternating current power supply is negative, the power inductor is configured to receive electric energy from the alternating current power supply to perform reverse charging.

With reference to the second aspect, in some possible implementations, the PFC apparatus includes a controller and a third switching transistor. When the third switching transistor is turned on, the power inductor is configured to perform charging. When the third switching transistor is turned off, the power inductor is configured to supply power to the capacitor in the forward manner. The controller is configured to control on/off of the third switching transistor based on the detection signal.

According to a third aspect, a chip system is provided. The chip system includes the current detection apparatus according to the first aspect.

According to a fourth aspect, an electronic device is provided, including the bridgeless power factor correction PFC apparatus according to the second aspect.

### BRIEF DESCRIPTION OF DRAWINGS

FIG. 1 is a schematic structural diagram of a current monitoring apparatus;
FIG. 2 is a schematic structural diagram of an alternating current―direct current conversion circuit with a PFC function;
FIG. 3 is a schematic structural diagram of a boost direct current―direct current conversion circuit;
FIG. 4 is a schematic diagram of an operating waveform of a PFC circuit in a continuous conduction mode;
FIG. 5 is a schematic diagram of an operating waveform of a PFC circuit in a discontinuous conduction mode;
FIG. 6 is a schematic structural diagram of a bridgeless PFC circuit with a totem pole structure;
FIG. 7 is a schematic structural diagram of a bridgeless PFC circuit with an alternating current switch structure;
FIG. 8 is a schematic structural diagram of a bridgeless PFC circuit with a dual-inductor structure;
FIG. 9 is a schematic structural diagram of a current detection manner;
FIG. 10 is a schematic structural diagram of another current detection manner;
FIG. 11 is a schematic structural diagram of a current detection apparatus according to an embodiment of this application;
FIG. 12 is a schematic structural diagram of another current detection apparatus according to an embodiment of this application;
FIG. 13(a) and FIG. 13(b) are equivalent circuit diagrams of a current detection apparatus;
FIG. 14 is an operating waveform of a current detection apparatus according to an embodiment of this application;
FIG. 15 is a schematic structural diagram of a PFC apparatus according to an embodiment of this application;
FIG. 16 is a schematic structural diagram of another PFC apparatus according to an embodiment of this application; and
FIG. 17 is a schematic structural diagram of still another PFC apparatus according to an embodiment of this application.

### DESCRIPTION OF EMBODIMENTS

The following describes technical solutions of this application with reference to accompanying drawings.

In some circuits, a voltage at two ends of some components in the circuits or a current flowing through some components needs to be detected, so as to control the circuits. For example, a power factor correction (power factor correction, PFC) circuit generally needs to detect a current flowing through an inductor in a circuit.

Higher power density and higher conversion efficiency are two important subjects concerning switch-mode power supplies. Especially in the information and communications (information and communication, ICT) field and the consumer electronic product field, miniaturization and high efficiency of a power supply component are particularly important for reducing product costs and improving user experience.

A phase difference between a current and a voltage results in a power loss. Therefore, to improve power utilization, the phase difference between the current and the voltage can be adjusted. A PFC technology is used to adjust a phase difference between a voltage and a current, to increase a power factor of an electricity consuming device. Active power factor correction is to increase an input power factor by using an active circuit (active circuit), to control a switch component to make an input current waveform follow an input voltage waveform.

According to the international electrotechnical commission (international electrotechnical commission, IEC) 61000-3-12 standard, for an electricity consuming device with an input power of over 75 watt (Watt, W), a limitation is imposed on harmonic of an input current. Therefore, when an input power of a power supply is greater than 75 W, a PFC circuit usually needs to be used.

FIG. 2 is a schematic structural diagram of an alternating current (alternating current, AC)-direct current (direct current, DC) conversion circuit with a PFC function.

An alternating current mains input needs to undergo electromagnetic interference (electromagnetic interference, EMI) protection/filtering, rectification, power factor correction, and DC-DC conversion, to finally obtain an output direct current.

To meet requirements of global standards, an input voltage range of a power supply usually covers alternating voltages of 90 to 264 volts (volt, V). Therefore, a level-1 power conversion circuit, that is, a PFC circuit, needs to maintain high conversion efficiency in a wide input range.

FIG. 3 is a schematic structural diagram of a boost (boost) DC-DC conversion circuit. The circuit shown in FIG. 3 can implement a PFC function and a DC-DC conversion function.

The boost DC-DC converter includes an inductor L, a diode D, a switching transistor Q, and an output capacitor C. A first end of the inductor L is configured to receive a direct voltage Vin. A second end of the inductor L, an anode of the diode D, and a first end of the switching transistor Q are connected. A cathode of the diode D is connected to a first end of the output capacitor C. A second end of the output capacitor C and a second end of the switching transistor Q are grounded. A load resistor R is connected in parallel to the capacitor C. A power supply voltage, that is, the input voltage Vin of the boost (boost) DC-DC conversion circuit, is a direct voltage. An output voltage at two ends of the load resistor R is Vo.

When the switching transistor Q is turned on, a current flows through the inductor coil L. Before the inductor coil is saturated, the current increases linearly, and electric energy is stored in the inductor coil in a form of magnetic energy. In this case, the capacitor C discharges to provide energy to a load. When the switching transistor Q is turned on, a current flowing through the inductor L is referred to as an excitation current.

When the switching transistor Q is turned off, a self-induced electromotive force VL is generated at two ends of the inductor L, so that a current direction remains unchanged. In this way, VL is connected in series to the power supply VIN to supply power to the capacitor and the load, to implement voltage boosting and make a voltage and a current equal in phase. When the switching transistor Q is turned off, a current flowing through the inductor L is referred to as a demagnetization current.

The switching transistor usually uses a metal-oxide-semiconductor field-effect transistor (metal-oxide-semiconductor field effect transistor, MOSFET) (that is, a metal oxide semiconductor (metal-oxide-semiconductor, MOS) transistor).

To implement AC-DC conversion, a conventional boost PFC circuit includes an input rectifier bridge. An AC power supply can serve as an input of the rectifier bridge, and an output of the rectifier bridge serves as a power supply input of the DC-DC conversion circuit shown in FIG. 3.

The circuit shown in FIG. 3 may operate in a continuous conduction mode (continuous conduction mode, CCM), a boundary conduction mode (boundary conduction mode, BCM), and a discontinuous conduction mode (discontinuous conduction mode, DCM).

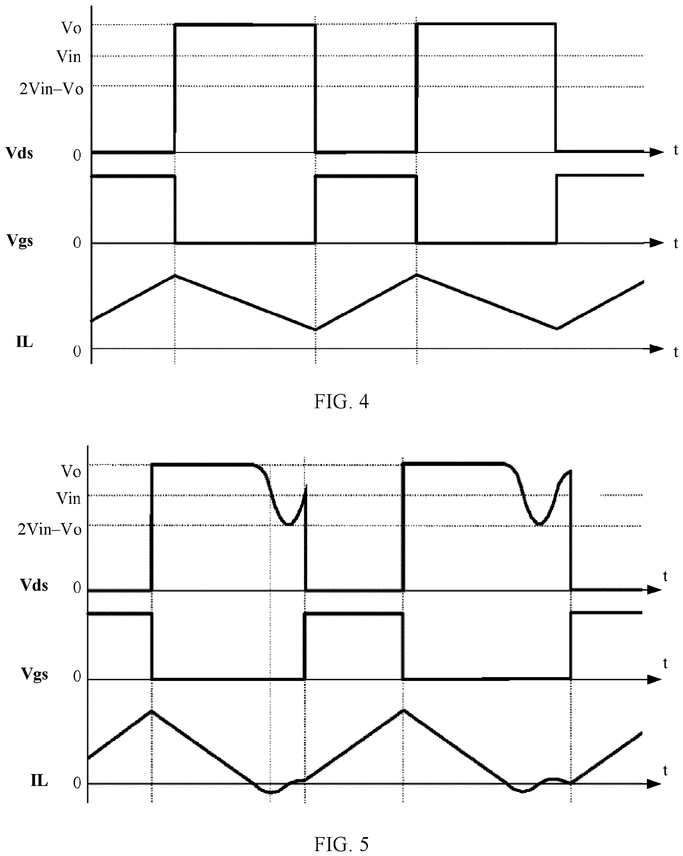

FIG. 4 is an operating waveform of the PFC circuit in the continuous conduction mode. As an example for description, the switching transistor Q is an N-channel MOS (n-channel MOS, NMOS) transistor.

When an operating frequency of the switching transistor Q is fixed, in case of a low-voltage input or in a heavy load state, a PFC circuit system enters the CCM mode.

A gate-source voltage Vgs between a gate (gate, g) and a source (source, s) of the NMOS controls on/off between the source and a drain (drain, d). In the CCM mode, under control of Vgs, a drain-source voltage Vds between the source and the drain of the NMOS in the PFC circuit and a current IL flowing through the inductor L are in waveforms shown in FIG. 4.

IL is always greater than zero. When the switching transistor Q is turned on, before the inductor coil is saturated, the current increases linearly, and electric energy is stored in the inductor coil in a form of magnetic energy. After the switching transistor Q is turned off, IL decreases linearly.

A waveform of Vds is a square wave. When Vgs controls the switching transistor Q to turn on, Vds is 0. When Vgs controls the switching transistor Q to turn off, Vds is equal to the output voltage Vo.

When the switching transistor Q is turned off, a current in the inductor is not zero. In other words, a current of a freewheeling diode D is not zero, that is, a forward voltage exists at two ends of the freewheeling diode D. Therefore, if the freewheeling diode D is turned off after the switching transistor Q is turned off, a process in which the freewheeling diode D enters an off state from a forward-on state takes some time, and a reverse recovery current in a reverse turn-off process of the freewheeling diode D is relatively high, resulting in a relatively large loss. Zero current detection (zero current detect, ZCD) is performed on the current in the inductor, and the switching transistor Q is turned off after the freewheeling diode D is turned off. This can reduce a loss brought by the freewheeling diode D.

FIG. 5 is an operating waveform of the PFC circuit in the discontinuous conduction mode. As an example for description, the switching transistor Q is an N-channel MOS (n-channel MOS, NMOS) transistor.

When an operating frequency of the switching transistor Q is fixed, in case of a high-voltage input or in a light load state, a PFC circuit system enters the DCM mode.

In the DCM mode, under control of Vgs, a drain-source voltage Vds between a source and a drain (drain, D) of the NMOS in the PFC circuit and a current IL flowing through the inductor L are in waveforms shown in FIG. 5.

After the switching transistor Q is turned off, IL decreases. After IL is decreased to zero, the inductor L oscillates with a capacitive element in the circuit. After IL is decreased to zero, Vds oscillates. When IL is zero, a value of Vds is a maximum value in the oscillation of Vds.

Turning the switching transistor Q on or off takes time, resulting in a switching loss. By reducing a voltage at two ends of the switching transistor Q when the switching transistor Q is turned on or off, that is, the drain-source voltage Vds of the NMOS, the switching transistor Q is turned on when Vds is at a minimum voltage value in the oscillation process of Vds after IL is decreased to zero, thereby implementing conduction at a ringing valley and reducing the switching loss.

Therefore, in the conventional boost PFC circuit, zero-crossing detection can be implemented for the current in the inductor by detecting an auxiliary winding of the inductor. A voltage generated by the auxiliary winding of the inductor and a voltage in the inductor L are opposite in polarity. When the switching transistor Q is turned on, the voltage in the auxiliary winding is a negative value and is in proportion to amplitude of a rectified alternating voltage. When the switching transistor Q is turned off, an inducting voltage in the switching transistor Q is a positive value and is in proportion to a difference between an output voltage and a rectified alternating voltage. After the current flowing through the inductor L is decreased to zero, the inductor L resonates with stray capacitance of the switching transistor Q, and resonance of the voltage of the auxiliary winding is decreased. When the voltage generated by the auxiliary winding is lower than a specified threshold voltage (threshold voltage), the switching transistor Q is controlled to turn on. The loss brought by the switching transistor Q can be reduced by properly designing the threshold voltage.

In the conventional boost PFC circuit, a loss caused by a voltage drop of a rectifier diode in the input rectifier bridge causes low conversion efficiency in case of a low-voltage input. In case of a 90 V alternating voltage input, a conversion efficiency loss brought by the input rectifier bridge usually reaches approximately 1.5%, becoming a bottleneck that limits an increase in power density. To resolve the loss problem brought by the rectifier bridge and improve conversion efficiency (especially conversion efficiency in case of a low-voltage input), a bridgeless PFC topology can be used.

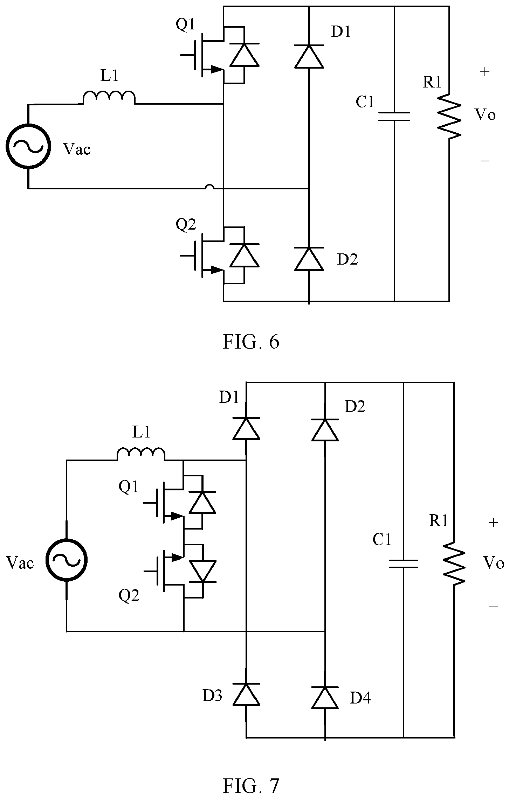

FIG. 6, FIG. 7, and FIG. 8 are structural diagrams of three bridgeless PFC circuit topologies. All the three structures can effectively reduce a loss brought by a diode of a rectifier circuit in a conventional PFC circuit and improve conversion efficiency.

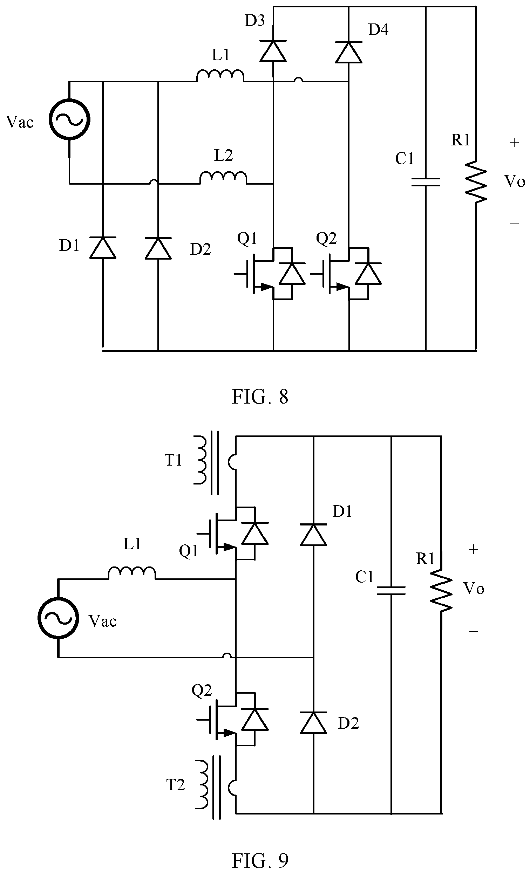

In a bridgeless PFC circuit with a dual-inductor structure shown in FIG. 8, in a positive half cycle and a negative half cycle of an AC power supply Vac, a current respectively flows through an inductor L1 and an inductor L2. Two inductors, namely the inductor L1 and the inductor L2, are used in the bridgeless PFC circuit. This is unfavorable for miniaturization design.

In a bridgeless PFC circuit with a totem pole structure shown in FIG. 6 and in a bridgeless PFC circuit with an AC switch structure shown in FIG. 7, a current flows through the same inductor in both a positive half cycle and a negative half cycle of an input of an AC power supply. Therefore, only one power inductor is needed. These structures are two mainstream structures for high-density miniaturized power supplies at present.

In the bridgeless PFC circuit shown in FIG. 6, when the alternating current power supply Vac is positive, a body diode of a switching transistor Q1 serves as a freewheeling diode.

When a switching transistor Q2 is turned on, the switching transistor Q1 is turned off, the power supply, an inductor L1, the switching transistor Q2, and a diode D2 form a loop, and the power supply charges the inductor L1.

When the switching transistor Q2 is turned off, the body diode of the switching transistor Q1 is turned on, and then the switching transistor Q1 is controlled to turn on. If the switching transistor Q1 is turned off, the power supply, the body diode of the switching transistor Q1, a capacitor C1 (and a load resistor R1 connected in parallel to the capacitor C1), and the diode D2 form a loop, and the power supply and the inductor L1 charge the capacitor C1. If the switching transistor Q1 is turned on, the power supply, the switching transistor Q1, the capacitor C1 (and the load resistor R1 connected in parallel to the capacitor C1), and the diode D2 form a loop, and the power supply and the inductor L1 charge the capacitor C1.

A time between two consecutive times of conduction of the switching transistor Q2 may be referred to as a switching cycle.

When the alternating current power supply Vac is negative, a body diode of the switching transistor Q2 serves as a freewheeling diode.

When the switching transistor Q1 is turned on, the power supply, the inductor L1, the switching transistor Q1, and a diode D1 form a loop, and the power supply charges the inductor L1.

When the switching transistor Q1 is turned off, the body diode of the switching transistor Q2 is turned on, and then the switching transistor Q2 is controlled to turn on. If the switching transistor Q2 is turned off, the power supply, the inductor L1, the diode D1, the capacitor C1 (and the load resistor R1 connected in parallel to the capacitor C1), and the body diode of the switching transistor Q2 form a loop, and the power supply and the inductor L1 charge the capacitor C1. If the switching transistor Q1 is turned on, the power supply, the inductor L1, the diode D1, the capacitor C1 (and the load resistor R1 connected in parallel to the capacitor C1), and the switching transistor Q2 form a loop, and the power supply and the inductor L1 charge the capacitor C1.

A time between two consecutive times of conduction of the switching transistor Q1 may be referred to as a switching cycle.

There are only two diode components between the alternating current power supply and the capacitor C1. This reduces a voltage loss.

In the bridgeless PFC circuit shown in FIG. 7, a switching transistor Q1 and a switching transistor Q2 are connected in series, to form a switch circuit. The switching transistor Q1 and the switching transistor Q2 are turned on or off at the same time. A source of the switching transistor Q1 is connected to a source of the switching transistor Q2. A direction of a current flowing through the switch circuit changes as the alternating current power supply alternates between positive and negative. Because of a body diode, a MOSFET cannot completely turn off a current in a direction. Therefore, a body diode of the switching transistor Q1 and a body diode of the switching transistor Q2 are opposite in direction, and the switching transistor Q1 and the switching transistor Q2 are connected in series to form a switch circuit.

When the alternating current power supply Vac is positive, an inductor L1, a diode D1, a diode D4, the switching transistor Q1, the switching transistor Q2, and a capacitor C1 form a boost DC-DC conversion circuit. When the switching transistor Q1 and the switching transistor Q2 are turned on, an excitation current flows through the inductor L1, the switching transistor Q1, and the switching transistor Q2. When the switching transistor Q1 and the switching transistor Q2 are turned off, a demagnetization current flows through the inductor L1, the diode D1, the capacitor C1, and the diode D4. A time between two consecutive times of conduction of the switching transistor Q1 and the switching transistor Q2 may be referred to as a switching cycle.

When the alternating current power supply Vac is negative, the inductor L1, a diode D2, the switching transistor Q1, the switching transistor Q2, a diode D3, and the capacitor C1 form a boost DC-DC conversion circuit. When the switching transistor Q1 and the switching transistor Q2 are turned on, an excitation current flows through the inductor L1, the switching transistor Q1, and the switching transistor Q2. When the switching transistor Q1 and the switching transistor Q2 are turned off, a demagnetization current flows through L1, the diode D2, the capacitor C1, and the diode D3. A time between two consecutive times of conduction of the switching transistor Q2 may be referred to as a switching cycle.

There are only two diode components between the alternating current power supply and the capacitor C1. This reduces a voltage loss.

When the alternating current power supply Vac is negative, a current direction in the inductor L1, the switching transistor Q1, and the switching transistor Q2 is opposite to that in a positive half cycle. Therefore, current zero-crossing detection cannot be implemented for the positive and negative half cycles of the input of the AC power supply of the bridgeless PFC circuits shown in FIG. 6 and FIG. 7 by simply comparing a voltage generated by an auxiliary winding with a threshold voltage by using a comparator.

In the bridgeless PFC circuit with an AC switch structure shown in FIG. 7, if the switching transistor Q1 and the switching transistor Q2 are not steady on and are turned on and off at a fixed frequency, a current in the inductor is not detected, and the PFC circuit enters the CCM or the DCM based on load status. In the CCM, reverse recovery of a freewheeling diode (for example, D1 and D3) takes a long time, and a high reverse voltage is imposed. Therefore, the reverse recovery results in a large loss, ultimately leading to low conversion efficiency. To improve conversion efficiency, a freewheeling loop designed in this solution generally needs to use a wide bandgap semiconductor component. D1 and D3 in FIG. 7 need to use a silicon carbide SiC diode, resulting in increased system costs.

The bridgeless PFC circuit with a totem pole structure shown in FIG. 6 also has similar problems. Reverse recovery of a body diode of a freewheeling MOSFET (for example, Q1 and Q2) in FIG. 6 takes a long time, and a gallium nitride GaN or silicon carbide SiC power switching transistor may be used.

In addition, a system does not perform zero-crossing detection on a current in the inductor. Therefore, a MOSFET cannot implement conduction at a ringing valley. The switch component MOSFET is in a hard switching state, resulting in a large switching loss and relatively low conversion efficiency. In addition, a switching frequency is limited. This is unfavorable for miniaturization design.

Two current transformers may be used to detect the current in the inductor.

FIG. 9 is a schematic circuit diagram illustrating detection on the bridgeless PFC circuit with a totem pole structure shown in FIG. 6.

In a positive half cycle of an input of an alternating current power supply Vac, Q2 is a magnetizing loop power transistor, and Q1 is a demagnetizing loop power transistor. In this case, a demagnetization current flows through a current transformer T1, and a secondary winding of T1 can be used to perform zero-crossing detection on a current in an inductor. Similarly, in a negative half cycle of the input of the alternating current power supply Vac, a demagnetization current flows through a current transformer T2, and a secondary winding of T2 can be used to detect zero-crossing of an induced current.

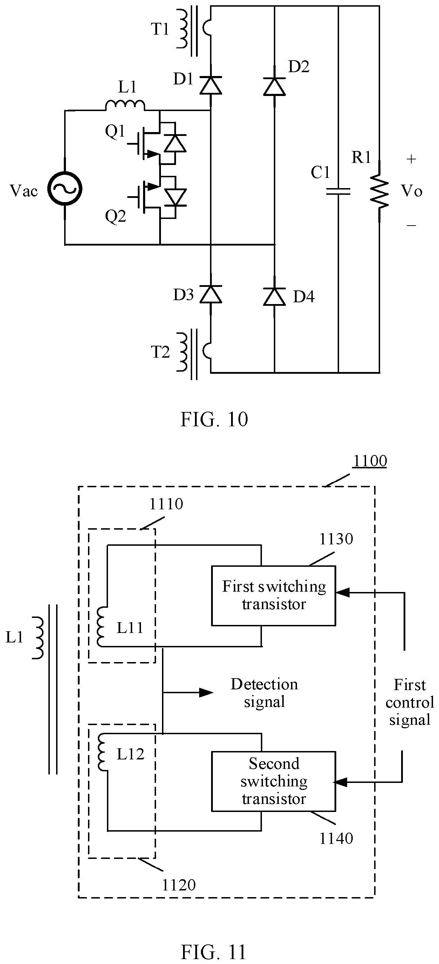

FIG. 10 is a schematic circuit diagram illustrating detection on the bridgeless PFC circuit with a totem pole structure shown in FIG. 7. In a positive half cycle of an input of an alternating current power supply Vac, a demagnetization current flows through a current transformer T1, and the current transformer T1 can be used to detect zero-crossing of an induced current. In a negative half cycle of the input of the alternating current power supply Vac, a demagnetization current flows through a current transformer T2, and the current transformer T2 can be used to detect zero-crossing of an induced current.

Two extra current transformers are added, resulting in a complex circuit structure and high circuit costs. In addition, the current transformers occupy a large footprint on a printed circuit board (printed circuit board, PCB). This is unfavorable for product miniaturization.

The circuit structure shown in FIG. 1 can be used to detect an induced current of the bridgeless PFC circuits shown in FIG. 6 and FIG. 7.

In FIG. 1, the inductor L1 is an inductor in a bridgeless PFC circuit. Whether the direction of the current flowing through the inductor L1 is positive or negative depends on whether the power supply in the bridgeless PFC circuit is positive or negative.

The inductor L11 and the inductor L12 are two auxiliary inductors and are electromagnetically coupled to the inductor L1. The inductor L11 and the inductor L12 may also be referred to as auxiliary windings of the inductor L1. The inductor L11 and the inductor L12 are connected in series. A voltage of the detection node A between the inductor L11 and the inductor L12 serves as an input of a positive terminal of a comparator (comparator, COMP) circuit. A reference voltage VR serves as an input of a negative terminal of the comparator circuit.

One end of the inductor L11 is connected to one end of the inductor L12. The other end of the inductor L11 and the other end of the inductor L12 are respectively connected to a ground potential through the switching transistor Q5 and the switching transistor Q6. A reference signal Vp is input to a control port of the switching transistor Q6. The reference signal Vp is inverted by an inverter (inverter, INVR) and then input to a control port of the switching transistor Q5. The reference signal Vp controls the switching transistor Q5 and the switching transistor Q6 to alternately turn on and off. The reference signal Vp is a square wave or a quasi-square wave in a same positive/negative direction as the AC power supply in the bridgeless PFC circuit. Therefore, the reference signal Vp can control one of the switching transistor Q5 and the switching transistor Q6 to turn on and the other one to turn off based on whether the AC power supply in the bridgeless PFC circuit is positive or negative. In this way, the inductor L11 and the inductor L12 provide a signal to a comparator as the AC power supply in the bridgeless PFC circuit alternates between positive or negative.

A resistor R2 and a resistor R3 may be connected in series between the inductor L11 and the inductor L12. A connection point of the resistor R2 and the resistor R3 may serve as the detection node A. A voltage of the detection node A serves as the input of the positive terminal of the comparator circuit.

With development of circuit manufacturing technologies, an operating frequency of a circuit is increased and performance of the circuit is improved. In case of a relatively small processing dimension and a relatively high operating frequency, a coupling voltage and current generated because of coupling between metal conducting wires increase.

When the switching transistor Q5 is turned off, a potential of the end that is of the inductor L11 and that is connected to the switching transistor Q5 is floating. On a PCB board, charges exist in the switching transistor Q5 in an off state and can be transferred to the detection node A through a conducting wire. When a potential of the conducting wire between the detection node A and the switching transistor Q5 is changed because the conducting wire is subject to electromagnetic interference of other parts and components in the circuit, a potential of a connection point of the inductor L11 and the inductor L12 may be affected, causing relatively large interference and affecting detection accuracy.

To resolve the foregoing problems, an embodiment of this application provides a current detection apparatus, where when one auxiliary inductor outputs a detection signal, an induction circuit in which the other auxiliary inductor is located is short-circuited, to reduce interference, thereby improving detection accuracy.

FIG. 11 is a schematic structural diagram of a current detection apparatus according to an embodiment of this application.

The current detection apparatus 1100 is configured to detect a current flowing through a power inductor L1. The current detection apparatus 1100 may also be referred to as a current detection circuit.

The current detection apparatus includes a first induction circuit 1110 and a second induction circuit 1120, where the first induction circuit 1110 includes a first auxiliary inductor L11 that is coupled to the power inductor L1, and the second induction circuit 1120 includes a second auxiliary inductor L12 that is coupled to the power inductor L1. A detection node between a first end of the first induction circuit 1110 and a first end of the second induction circuit 1120 is configured to output a detection signal.

An auxiliary inductor may be an auxiliary winding of the power inductor L1.

That the first auxiliary inductor L11 is coupled to the power inductor L1 may also be referred to as: The first auxiliary inductor L11 and the power inductor L1 are electromagnetically coupled. Because the first auxiliary inductor L11 and the power inductor L1 are electromagnetically coupled, the first auxiliary inductor L11 can sense a current change in the power inductor L1. When a current flowing through the power inductor L1 is changed, an induced electromotive force is generated at two ends of the first auxiliary inductor L11.

The first auxiliary inductor L11 may form a transformer with the power inductor L1. The second auxiliary inductor L 12 may form a transformer with the power inductor L 1. A quantity of coil turns of the first auxiliary inductor L11 may be less than a quantity of coil turns of the power inductor L1. In other words, the induced electromotive force generated by the first auxiliary inductor L11 may be less than a voltage at two ends of the power inductor L1. The voltage at the two ends of the power inductor L1 may be several multiples of a voltage at two ends of the first auxiliary inductor L11.

The current detection apparatus 1100 includes a first switching transistor 1130 and a second switching transistor 1140, where the first switching transistor 1130 and the first induction circuit 1110 are connected in parallel, and the second switching transistor 1140 and the second induction circuit 1120 are connected in parallel.

When an alternating current power supply of a circuit in which the power inductor L1 is located is positive, the first switching transistor 1130 is turned on to short-circuit the first induction circuit 1110, and the second switching transistor 1140 is turned off to enable the second induction circuit 1120 to output the detection signal. When the alternating current power supply of the circuit in which the power inductor L1 is located is negative, the second switching transistor 1140 is turned on to short-circuit the second induction circuit 1120, and the first switching transistor 1130 is turned off to enable the first induction circuit 1110 to output the detection signal.

The first switching transistor 1130 and the second switching transistor 1140 may be turned on or off based on a first control signal.

The first control signal controls on and off of the first switching transistor 1130 and the second switching transistor 1140. The first control signal may be generated by a controller. The controller may be located inside the current detection apparatus 1000, or may be located outside the current detection apparatus 1000.

The first control signal includes a control signal of the first switching transistor 1130 and a control signal of the second switching transistor 1140. The control signal of the first switching transistor 1130 controls on and off of the first switching transistor 1130. A second control signal of the second switching transistor 1140 controls on and off of the second switching transistor 1140.

When the alternating current power supply of the circuit in which the power inductor L1 is located is positive, the first control signal controls the first switching transistor 1130 to turn on to short-circuit the first induction circuit 1110, and controls the second switching transistor 1140 to turn off to enable the second induction circuit 1120 to output the detection signal. When the alternating current power supply of the circuit in which the power inductor L1 is located is negative, the first control signal controls the second switching transistor 1140 to turn on to short-circuit the second induction circuit 1120, and controls the first switching transistor 1130 to turn off to enable the first induction circuit 1110 to output the detection signal.

That the second induction circuit 1120 outputs the detection signal may be construed as: The second auxiliary inductor L12 outputs the detection signal.

The first switching transistor 1130 may be a voltage-controlled switch component or a current-controlled switch component. For example, the first switching transistor 1130 may be an NMOS transistor. A source of the first switching transistor 1130 may be connected to a reference ground potential of the current detection apparatus 1100.

The second switching transistor 1140 may be a voltage-controlled switch component or a current-controlled switch component. The second switching transistor 1140 may be an NMOS transistor. A source of the second switching transistor 1140 may be connected to the reference ground potential of the current detection apparatus 1100.

When the NMOS transistor is turned on, a gate-source voltage of the NMOS transistor needs to be greater than a threshold voltage. A source of the NMOS transistor is connected to the reference ground potential of the current detection apparatus 1100. This can reduce difficulty in controlling conduction of the NMOS and reduce a requirement on a gate voltage, thereby reducing difficulty in setting the first control signal.

An alternating current power supply of the power inductor L1 may also be construed as the alternating current power supply of the circuit in which the power inductor L1 is located, and the alternating current power supply supplies power to the power inductor L1.

When the alternating current power supply is positive, the first switching transistor 1130 is controlled to turn on, to short-circuit the first induction circuit. The first induction circuit and the first switching transistor 1130 that is turned on form a loop, to prevent the first induction circuit from interfering with a detection result of the second induction circuit, thereby improving detection accuracy.

A voltage generated by the second auxiliary inductor in the second induction circuit may be detected. Alternatively, resistors may be connected in series to divide a voltage generated by the second auxiliary inductor, thereby implementing detection.

The current detection apparatus 1100 may include a first resistive circuit and a second resistive circuit. The first resistive circuit and the second resistive circuit are configured to divide the voltage generated by the second auxiliary inductor.

In a possible embodiment, a second end of the first induction circuit 1110 may be connected to a first reference potential. The first resistive circuit may be located between the detection node and the first end of the first induction circuit 1110. In another possible embodiment, a second end of the first induction circuit 1110 may be connected to a first end of the first resistive circuit, and a second end of the first resistive circuit is connected to a first reference potential.

Similarly, in a possible embodiment, a second end of the second induction circuit 1120 may be connected to a second reference potential. The second resistive circuit may be located between the detection node and the first end of the second induction circuit 1120. In another possible embodiment, a second end of the second induction circuit 1120 may be connected to a first end of the second resistive circuit, and a second end of the second resistive circuit is connected to a second reference potential.

The first reference potential and the second reference potential may be equal or unequal. The first reference potential and the second reference potential may be both equal to the reference ground potential. A potential may also be understood as a potential difference or a voltage relative to the zero potential. The reference ground potential is a reference voltage of the zero potential.

Preferably, the current detection apparatus 1100 may further include a voltage divider circuit. The voltage divider circuit includes a first resistive circuit and a second resistive circuit that are connected in series. The voltage divider circuit is connected in series to the first induction circuit and the second induction circuit. A first end of the voltage divider circuit is connected to the first induction circuit, and a second end of the voltage divider circuit is connected to the second induction circuit.

The voltage divider circuit is connected in series to the first induction circuit and the second induction circuit. When the first induction circuit is short-circuited, the second induction circuit outputs the detection signal by using a detection node in the voltage divider circuit. When the second induction circuit is short-circuited, the first induction circuit outputs the detection signal by using a detection node in the voltage divider circuit. A direction of a current flowing through the voltage divider circuit when the first induction circuit is short-circuited is opposite to that of a current flowing through the voltage divider circuit when the second induction circuit is short-circuited. The first induction circuit and the second induction circuit may output the detection signal through the same voltage divider circuit. This can reduce a quantity of resistors in a circuit, thereby decreasing a footprint of the current detection apparatus.

To reduce power consumption of the current detection apparatus 1100, in the voltage divider circuit, a resistance of the first resistive circuit may be greater than 1 kΩ. A resistance of the second resistive circuit may also be greater than 1 kΩ.

The second induction circuit 1120 may include a first current limiting resistor that is connected in series to the second auxiliary inductor L12. A value of the first current limiting resistor may be great. The first current limiting resistor may be greater than 1 kiloohm (kiloohm, kΩ).

The current limiting resistor is added to the second induction circuit. This can decrease a short-circuit current when the second induction circuit is short-circuited, thereby reducing power consumption of the current detection apparatus and decreasing an amount of heat generated by the current detection apparatus.

Similarly, the first induction circuit 1110 may also include a second current limiting resistor that is connected in series to the first auxiliary inductor L11. The second current limiting resistor may be greater than 1 kΩ.

The current detection apparatus 1100 may further include a comparator. The comparator is configured to receive the detection signal output by the first auxiliary inductor or the second auxiliary inductor, compare the detection signal with a reference signal, and output a comparison signal.

The reference signal may be a constant reference voltage. The reference voltage is greater than or equal to 0 V.

The detection signal can be compared with the reference signal by using a simple comparator circuit, to detect the current in the power inductor.

The power inductor L1 may be an inductor in a PFC apparatus. The PFC apparatus is configured to convert an alternating voltage output by an alternating current power supply to a direct voltage. The PFC apparatus may also be referred to as a PFC circuit or a bridgeless PFC circuit. For a specific structure of the PFC apparatus, refer to FIG. 6 and FIG. 7.

The current detection apparatus provided in this embodiment of this application may be implemented by using a PCB board or an integrated circuit chip. On the PCB board, current zero-crossing detection can be implemented for the power inductor by adding auxiliary inductors and a small quantity of discrete devices to the power inductor.

When the power inductor L1 is an inductor in a PFC apparatus, the alternating current power supply of the power inductor is an alternating current power supply in the PFC apparatus.

The power inductor L1 is configured to supply power to a capacitor in the PFC apparatus in a forward manner. When the power inductor L1 supplies power to the capacitor in a forward manner, the capacitor is charged in a forward manner.

When the alternating current power supply in the PFC apparatus is positive, the power inductor L1 is configured to receive electric energy from the power supply and perform forward charging. In other words, the alternating current power supply charges the power inductor L1 in a forward manner. When the alternating current power supply in the PFC apparatus is negative, the power inductor L1 is configured to receive electric energy from the power supply and perform reverse charging. In other words, the alternating current power supply charges the power inductor L1 in a reverse manner.

The current detection apparatus provided in this embodiment of this application is applied to the PFC apparatus, to avoid a CCM operating state of a circuit and avoid use of expensive wide bandgap semiconductor components. Moreover, this is favorable for implementing miniaturization design of a power supply. By using the technical solution provided in this embodiment of this application, large-sized current transformers are not required, so that small space is occupied. In addition, the solution can implement conduction at a ringing valley, reduce a switching loss of a MOSFET, improve power supply conversion efficiency, and facilitate implementation of miniaturization design.

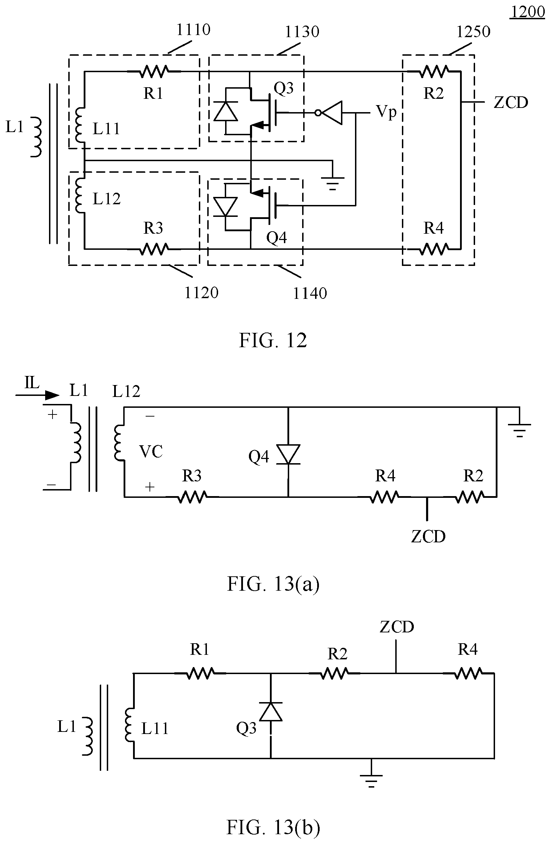

FIG. 12 is a schematic structural diagram of a current detection apparatus 1200 according to an embodiment of this application.

The current detection apparatus 1200 is configured to detect an alternating current flowing through a power inductor L1. The power inductor L1 may be a power inductor L1 in a PFC circuit shown in FIG. 6 or FIG. 7.

The current detection apparatus 1200 includes a first induction circuit 1110 and a second induction circuit 1120. The first induction circuit 1110 includes a first auxiliary inductor L11 and a current limiting resistor R1. The second induction circuit 1120 includes a second auxiliary inductor L12 and a current limiting resistor R3. The first auxiliary inductor L11 and the power inductor L1 are electromagnetically coupled. The second auxiliary inductor L12 and the power inductor L1 are electromagnetically coupled.

The current detection apparatus 1200 includes a switching transistor Q3 and a switching transistor Q4. The switching transistor Q3 is a first switching transistor 1130, and the switching transistor Q4 is a second switching transistor 1140. The switching transistor Q3 and the switching transistor Q4 are both NMOS transistors. The switching transistor Q3 is connected in parallel to the first induction circuit 1110. The switching transistor Q4 is connected in parallel to the second induction circuit 1120.

When an alternating current is positive, a first control signal Vp is at a high level and controls the switching transistor Q4 to turn off. The first control signal Vp is at a low level after passing through an inverter INVR and controls the switching transistor Q3 to turn on.

When the switching transistor Q3 is turned on, the first induction circuit 1110 is short-circuited, and an induced electromotive force generated at two ends of the first auxiliary inductor L11 is applied to two ends of the current limiting resistor R3, so that a voltage value of a detection signal ZCD is not affected.

When the alternating current is negative, the first control signal Vp is at a low level and controls the switching transistor Q3 to turn off. The first control signal Vp is at a high level after passing through the inverter INVR and controls the switching transistor Q4 to turn on.

When the switching transistor Q4 is turned on, the second induction circuit 1120 is short-circuited, and an induced electromotive force generated at two ends of the first auxiliary inductor L12 is applied to two ends of the current limiting resistor R1, so that a voltage value of a detection signal ZCD is not affected.

The current detection apparatus 1200 includes a voltage divider circuit 1250. The voltage divider circuit 1250 includes a first resistor R2 and a second resistor R4.

When the alternating current is positive and the switching transistor Q4 is turned off, an equivalent circuit diagram of the current detection apparatus 1200 is shown in FIG. 13(a).

When the alternating current is negative and the switching transistor Q3 is turned off, an equivalent circuit diagram of the current detection apparatus 1200 is shown in FIG. 13(b).

FIG. 13(a) is an equivalent circuit diagram of the current detection apparatus in a positive half cycle of the alternating current power supply.

The second auxiliary inductor L12 generates an induced electromotive force VC.

A body diode exists between a source and a substrate of the switching transistor Q4. That the switching transistor Q4 is turned off is equivalent that the body diode of the switching transistor Q4 is connected in parallel to the voltage divider circuit.

An equivalent circuit diagram of the bridgeless PFC circuit shown in FIG. 6 or FIG. 7 in a switching cycle is shown in FIG. 3. A circuit shown in FIG. 3 is used as an example to describe an operating principle in the equivalent circuit diagram of the current detection apparatus shown in FIG. 13(a).

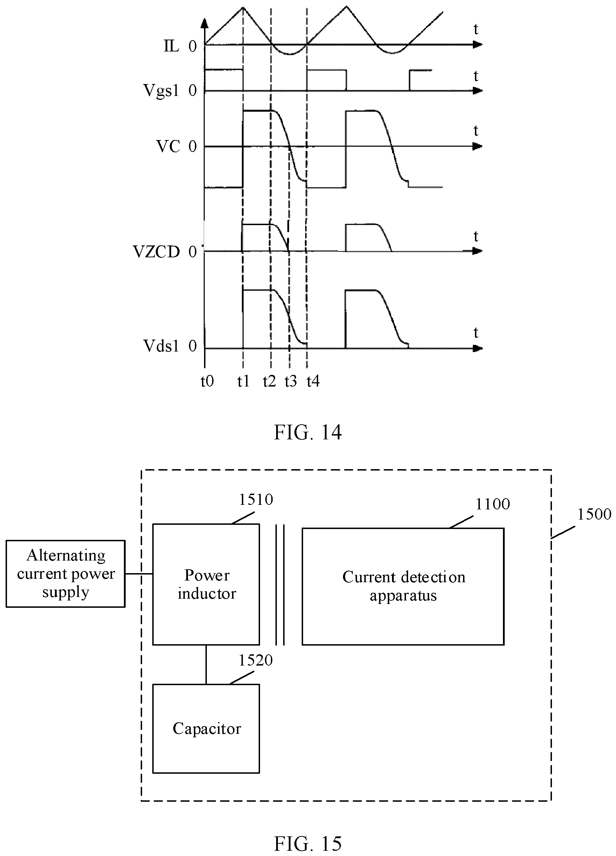

FIG. 14 shows operating waveforms of the current detection apparatus shown in FIG. 13(a).

In a time period t0-t1, a gate-source voltage of a MOSFET Q controls the MOSFET Q to turn on. In this case, the gate-source voltage Vgs1 of the MOSFET Q is at a high level, and a drain-source voltage Vds1 of the MOSFET Q is 0. A current IL flowing through the inductor L1 increases linearly. Voltage VC generated in the second auxiliary inductor L12 is opposite to a voltage in the inductor L1 in polarity, and is a negative value and is a constant.

Refer to FIG. 13(a). In the current detection apparatus, when VC is negative, the body diode of the switching transistor Q4 is turned on, and a voltage at two ends of the voltage divider circuit is fixedly a forward voltage of the body diode of the switching transistor Q4. Therefore, a voltage VZCD of a detection port ZCD is clamped and is almost equal to 0.

In a time period t1―t4, the gate-source voltage of the MOSFET Q controls the MOSFET Q to turn off. In this case, the gate-source voltage Vgs1 of the MOSFET Q is at a low level (that is, the voltage is equal to 0).

In a time period t1―t2, a freewheeling diode is turned on, and a load voltage is the drain-source voltage Vds1 of the MOSFET Q. Therefore, Vds1 is a constant greater than 0.

The current IL flowing through the inductor L1 decreases linearly, and the voltage VC generated in the auxiliary inductor L12 is the same as the voltage in the inductor L in polarity and is a positive value.

In the current detection apparatus, when VC is greater than 0, the body diode of the switching transistor Q4 is turned off. Therefore, the resistor R3, the resistor R4, and the resistor R2 implement voltage division. A value of VC is constant. Therefore, the voltage VZCD of the detection port ZCD is a constant greater than 0.

At t2, the current IL flowing through the inductor L1 is dropped to 0. In this case, a voltage drop caused because a diode D is turned on is ignored, and it can be considered that the drain-source voltage Vds1 of the MOSFET Q is equal to a voltage difference between two ends of a capacitor (that is, a voltage difference between two ends of a load). The freewheeling diode is at a critical point for turning on or off.

In a time period t2-t3, after the current in the inductor L1 reaches zero, the diode D is naturally turned off. In this case, the MOSFET Q is turned on, and the diode D does not generate a reverse recovery current.

The inductor L1 resonates with stray capacitance of the MOSFET Q, and resonance of the drain-source voltage Vds1 of the MOSFET Q decreases. The current IL is reversed, so that IL is less than 0. A voltage VC generated at two ends of the second auxiliary inductor L12 decreases, and the voltage VZCD of the port ZCD decreases.

At t3, the current IL flowing through the inductor L is decreased to a minimum value, and VC and VZCD are decreased to 0.

In a time period t3-t4, oscillation of VC decreases and is less than 0, and VZCD is clamped and is almost equal to 0. Resonance of Vds1 continues to decrease, and the current IL increases.

At the moment t4, the current IL is increased to 0, VC and Vds1 are decreased to lowest points, and the MOSFET Q is controlled to turn on. This can reduce switch power consumption of the MOSFET Q.

Conduction of the MOSFET Q at a ringing valley can be implemented by controlling the MOSFET Q to turn on after a preset time delay when it is detected that VZCD is decreased to a point lower than a preset value. For example, the MOSFET Q is controlled to turn on after a delay of a quarter of an oscillation cycle when it is detected that VZCD is 0.

FIG. 13(b) is an equivalent circuit diagram of the current detection apparatus in a negative half cycle of the alternating current power supply.

The first auxiliary inductor L11 generates an induced electromotive force VC.

A body diode exists between a source and a substrate of the switching transistor Q4. That the switching transistor Q4 is turned off is equivalent that the body diode of the switching transistor Q4 is connected in parallel to the voltage divider circuit.

An operating principle of the current detection apparatus in the negative half cycle of the alternating current power supply is similar to that in the positive half cycle.

It should be understood that a coefficient of mutual inductance between the first auxiliary inductor L11 and the power inductor L1 may be the same as or different from a coefficient of mutual inductance between the second auxiliary inductor L12 and the power inductor L1.

When the coefficient of mutual inductance between the first auxiliary inductor L11 and the power inductor L1 is different from the coefficient of mutual inductance between the second auxiliary inductor L12 and the power inductor L1, resistances of the resistor R1 to the resistor R4 can be properly set. In this way, in a circuit in which a conversion circuit is located, in a case in which an alternating voltage of the power supply is greater than zero and in a case in which an alternating voltage of the power supply is less than zero, VZCDs are equal and the currents flowing through the power inductor L1 are equal in size and opposite in direction.

When the coefficient of mutual inductance between the first auxiliary inductor L11 and the power inductor L1 is the same as the coefficient of mutual inductance between the second auxiliary inductor L12 and the power inductor L1, the resistor R1 and the resistor R3 in the current detection apparatus may be equal or unequal in resistance. When the resistor R1 and the resistor R3 are equal in resistance, the resistor R2 and the resistor R4 are equal in resistance. When the resistor R1 and the resistor R3 are unequal in resistance, resistances of the resistor R2 and the resistor R4 can be properly designed. In this way, in a circuit in which a conversion circuit is located, in a case in which an alternating voltage of the power supply is greater than zero and in a case in which an alternating voltage of the power supply is less than zero, VZCDs are equal and the currents flowing through the power inductor L1 are equal in size and opposite in direction.

The current detection apparatus may be configured to perform detection for a power inductor in a bridgeless PFC circuit, and a circuit in which a conversion circuit is located may be a bridgeless PFC circuit. The bridgeless PFC circuit is configured to convert an alternating voltage output by an alternating current power supply to a direct voltage.

When the alternating current power supply of the bridgeless PFC circuit is positive, the power inductor is configured to receive electric energy from the power supply and perform forward charging. When the alternating current power supply of the bridgeless PFC circuit is negative, the power inductor is configured to receive electric energy from the power supply and perform reverse charging.

FIG. 15 is a schematic structural diagram of a PFC apparatus according to an embodiment of this application. The PFC apparatus may also be referred to as a PFC circuit.

The PFC apparatus 1500 includes a current detection apparatus 1110, a power inductor 1510, and a capacitor 1520.

The power inductor 1510 is configured to supply power to the capacitor 1520 in the PFC apparatus in a forward manner.

When an alternating current power supply of the PFC apparatus 1500 is positive, the power inductor 1510 is configured to receive the alternating current power supply and perform forward charging. When an alternating current power supply is negative, the power inductor 1510 is configured to receive the alternating current power supply and perform reverse charging.

The PFC apparatus may further include a controller and a third switching transistor.

When the third switching transistor is turned on, the power inductor is configured to perform charging. When the third switching transistor is turned off, the power inductor is configured to supply power to the capacitor in the forward manner.

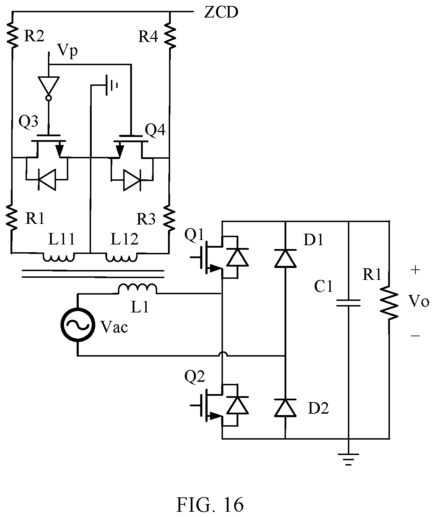

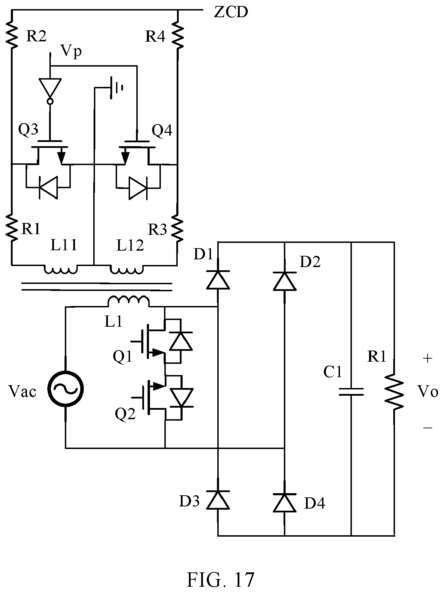

When the alternating current power supply is positive, the third switching transistor may be a switching transistor Q in an equivalent circuit of the PFC apparatus shown in FIG. 3. In a case in which the alternating current power supply is positive and in a case in which the alternating current power supply is negative, third switching transistors may be a same switching transistor or different switching transistors. For details, refer to descriptions of FIG. 16 and FIG. 17.

The controller may be configured to control conduction of the third switching transistor based on a detection signal. When the detection signal is less than or equal to a preset value, the controller may control the third switching transistor to turn on.

The current detection apparatus may include a comparator. The comparator is configured to receive a detection signal output by a first auxiliary inductor and a second auxiliary inductor, compare the detection signal with a reference signal, and output a comparison signal.

The comparison signal is obtained by comparing the detection signal and the reference signal. Therefore, that the controller controls conduction of the third switching transistor based on a detection signal may be: The controller controls the third switching transistor based on the comparison signal output by the comparator.

When a first reference potential and a second reference potential are unequal, different delays may be set for a case in which a current flowing through the power inductor is positive and a case in which a current flowing through the power inductor is negative. The third switching transistor in the PFC apparatus is controlled based on the different delays, so that the third switching transistor can implement conduction at a ringing valley in both the case in which the current flowing through the power inductor is positive and the case in which the current flowing through the power inductor is negative.

In the PFC apparatus, the power inductor is connected to the alternating current power supply.

When the alternating current power supply is positive, a first switch circuit is connected in parallel to a first capacitor circuit. The first capacitor circuit includes a load capacitor and a first diode that are connected in series. A negative electrode of the first diode is connected to a positive electrode of the capacitor, or a positive electrode of the first diode is connected to a negative electrode of the capacitor, so that the capacitor can be charged in a forward manner.

When the first switch circuit is turned on, the first capacitor circuit is short-circuited, and the alternating current power supply charges the power inductor in a forward manner.

When the first switch circuit is turned off, the alternating current power supply and the power inductor charge the load capacitor in a forward manner.

When the alternating current power supply is negative, a second switch circuit is connected in parallel to a second capacitor circuit. The second capacitor circuit includes a load capacitor and a second diode that are connected in series. A negative electrode of the second diode is connected to a positive electrode of the capacitor, or a positive electrode of the second diode is connected to a negative electrode of the capacitor, so that the capacitor can be charged in a forward manner.

When the second switch circuit is turned on, the second capacitor circuit is short-circuited, and the alternating current power supply charges the power inductor in a reverse manner.

When the second switch circuit is turned off, the alternating current power supply and the power inductor charge the load capacitor in a forward manner.

The third switching transistor is the first switching transistor or the second switching transistor. The first switching transistor and the second switching transistor may be the same switching transistor or different switching transistors.

FIG. 16 is a schematic structural diagram of a PFC apparatus according to an embodiment of this application.

The current detection apparatus provided in the embodiments of this application may be applied to a bridgeless PFC apparatus with a totem pole structure.

A switching transistor subject to conduction control by a controller is determined based on whether an alternating current power supply is positive or negative.

When the alternating current power supply is positive, the controller is configured to control conduction of a switching transistor Q1 based on a detection signal. In other words, when the alternating current power supply is positive, the switching transistor Q1 is equivalent to a switching transistor Q in the equivalent circuit diagram shown in FIG. 3.

When the alternating current power supply is negative, the controller is configured to control conduction of a switching transistor Q2 based on a detection signal. In other words, when the alternating current power supply is negative, the switching transistor Q2 is equivalent to a switching transistor Q in the equivalent circuit diagram shown in FIG. 3.

The controller controls conduction of a third switching transistor based on the detection signal. In other words, in the bridgeless PFC apparatus with a totem pole structure, when the alternating current power supply is positive, the switching transistor Q1 is the third switching transistor; and when the alternating current power supply is negative, the switching transistor Q2 is the third switching transistor.

FIG. 17 is a schematic structural diagram of a PFC apparatus according to an embodiment of this application.

The current detection apparatus provided in the embodiments of this application may be applied to a bridgeless PFC apparatus with an AC switch structure.

When an alternating current power supply is positive, a controller is configured to control conduction of a switching transistor Q1 and a switching transistor Q2 based on a detection signal. In other words, when the alternating current power supply is positive, the switching transistor Q1 and the switching transistor Q2 are equivalent to switching transistors Q in the equivalent circuit diagram shown in FIG. 3.

When the alternating current power supply is negative, the controller is configured to control conduction of the switching transistor Q1 and the switching transistor Q2 based on the detection signal. In other words, when the alternating current power supply is negative, the switching transistor Q1 and the switching transistor Q2 are equivalent to switching transistors Q in the equivalent circuit diagram shown in FIG. 3.

The controller controls conduction of a third switching transistor based on the detection signal. In other words, in the bridgeless PFC apparatus with a totem pole structure, the third switching transistor includes the switching transistor Q1 and the switching transistor Q2.

An embodiment of this application further provides a chip system. The chip system includes the current detection apparatus described above.

The chip system may be an application-specific integrated circuit (application specific integrated circuit, ASIC), or may be implemented by using a PCB.

An embodiment of this application further provides an electronic device. The electronic device includes the bridgeless power factor correction PFC apparatus described above.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A current detection apparatus, wherein the current detection apparatus is configured to detect an alternating current flowing through a power inductor, and the current detection apparatus comprises:
a first induction circuit and a second induction circuit, wherein the first induction circuit comprises a first auxiliary inductor that is coupled to the power inductor, the second induction circuit comprises a second auxiliary inductor that is coupled to the power inductor, and a detection node between a first end of the first induction circuit and a first end of the second induction circuit is configured to output a detection signal; and
a first switching transistor and a second switching transistor, wherein the first switching transistor and the first induction circuit are connected in parallel, and the second switching transistor and the second induction circuit are connected in parallel, wherein
when an alternating current power supply of a circuit in which the power inductor is located is positive, the first switching transistor is turned on to short-circuit the first induction circuit, and the second switching transistor is turned off to enable the second induction circuit to output the detection signal; or when the alternating current power supply of the circuit in which the power inductor is located is negative, the second switching transistor is turned on to short-circuit the second induction circuit, and the first switching transistor is turned off to enable the first induction circuit to output the detection signal.

2. The current detection apparatus according to claim 1, wherein the second induction circuit comprises a first current limiting resistor that is connected in series to the second auxiliary inductor.

3. The current detection apparatus according to claim 1 or 2, wherein the current detection apparatus comprises a voltage divider circuit, and the voltage divider circuit comprises a first resistive circuit and a second resistive circuit that are connected in series, the voltage divider circuit is connected in series to the first induction circuit and the second induction circuit, a first end of the voltage divider circuit is connected to the first end of the first induction circuit, a second end of the voltage divider circuit is connected to the first end of the second induction circuit, and the detection node is located between the first resistive circuit and the second resistive circuit.

4. The current detection apparatus according to any one of claims 1 to 3, wherein the first switching transistor is an N-type metal-oxide semiconductor field-effect transistor NMOS, and a source of the first switching transistor is connected to a reference ground potential of the current detection apparatus.

5. The current detection apparatus according to any one of claims 1 to 4, wherein the current detection apparatus further comprises a comparator, configured to receive the detection signal, compare the detection signal with a reference signal, and output a comparison signal.

6. The current detection apparatus according to any one of claims 1 to 5, wherein the power inductor is an inductor in a bridgeless power factor correction PFC apparatus, and the power inductor is configured to charge a capacitor in the PFC apparatus in a forward manner; and
when an alternating current power supply of the PFC apparatus is positive, the power inductor receives electric energy from the alternating current power supply to perform forward charging; or when the alternating current power supply of the PFC apparatus is negative, the power inductor receives electric energy from the alternating current power supply to perform reverse charging.

7. A bridgeless power factor correction PFC apparatus, the PFC apparatus comprises a power inductor, a capacitor, and the current detection apparatus according to any one of claims 1 to 5;
the power inductor is configured to supply power to the capacitor in the PFC apparatus in a forward manner; and when an alternating current power supply of the PFC apparatus is positive, the power inductor receives electric energy from the alternating current power supply to perform forward charging; or when the alternating current power supply of the PFC apparatus is negative, the power inductor receives electric energy from the alternating current power supply to perform reverse charging.

8. The PFC apparatus according to claim 7, wherein the PFC apparatus further comprises a controller and a third switching transistor;
when the third switching transistor is turned on, the power inductor is configured to perform charging; or when the third switching transistor is turned off, the power inductor is configured to supply power to the capacitor in the forward manner; and
the controller is configured to control on/off of the third switching transistor based on the detection signal.

9. An electronic device, comprising the bridgeless power factor correction PFC apparatus according to claim 7 or 8.
